# EUROPEAN PATENT APPLICATION

(11) **EP 4 443 238 A1**
(43) Date of publication of application: **09.10.2024**
(21) Application number: 23166310.5
(22) Date of filing: 03.04.2023
(51) Int. Cl.: G03F 7/00, F16L 55/04, F01N 1/00

(54) **SILENCER FOR THERMAL CONDITIONING SYSTEM AND LITHOGRAPHIC APPARATUS**

(71) Applicant: ASML Netherlands B.V., 5500 AH Veldhoven (NL)
(72) Inventor: REZAEIHA, Abdolrahim, 5500 AH Veldhoven (NL); HUANG, Zhuangxiong, 5500 AH Veldhoven (NL); JACOBS, Johannes, Henricus, Wilhelmus, 5500 AH Veldhoven (NL); VAN DE MEERENDONK, Remco, 5500 AH Veldhoven (NL); VERSPAY, Jacobus, Johannus, Leonardus, Hendricus, 5500 AH Veldhoven (NL); FEIJTS, Maurice, Wilhelmus, Leonardus, Hendricus, 5500 AH Veldhoven (NL); VAN DE WETERING, Nick, Hendricus, Martinus, 5500 AH Veldhoven (NL); VERMEULEN, Johannes, Petrus, Martinus, Bernardus, 5500 AH Veldhoven (NL); WIJCKMANS, Maurice, Willem, Jozef, Etiënne, 5500 AH Veldhoven (NL); KLAVER, Renatus, Gerardus, 5500 AH Veldhoven (NL)
(74) Representative: ASML Netherlands B.V.

(57) **Abstract**

A silencer is configured to silence an acoustic wave in a thermal conditioning fluid in a thermal conditioning fluid duct. The silencer comprises an open inlet configured to be connected to the thermal conditioning fluid duct to be in fluid communication with the thermal conditioning fluid, a silencer housing comprising an inner cavity connected to the open inlet, a compliant member arranged in the inner cavity, wherein the compliant member divides the inner cavity into a thermal conditioning fluid cavity and a gas cavity, wherein the thermal conditioning fluid cavity is connected to the open inlet and wherein the gas cavity forms a substantially closed space, wherein the gas cavity comprises a plurality of gas channels extending in a direction substantially perpendicular to a surface of the compliant member facing the gas cavity.

## Description

### FIELD

The present invention relates to a silencer, a thermal conditioning system comprising such a silencer, a lithographic apparatus comprising such thermal conditioning system, and a method of thermally conditioning an object of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Objects of the lithographic apparatus may be provided with a thermal conditioning system, which comprises a fluid duct for guiding a thermal conditioning fluid. The fluid duct is configured to guide the thermal conditioning fluid to the object that is to be thermally conditioned, through the object and to discharge the thermal conditioning fluid from the object. The object may for example be a projection system mirror of a projection system of the lithographic apparatus or may for example be a stage, such as a wafer table of the lithographic apparatus. It has been observed that the thermal conditioning duct may guide disturbances, such as vibrations, to the object. This may be undesirable, as such disturbances may result in e.g. a vibration or other movement of the object. It has been suggested to provide the thermal conditioning duct with a silencer which may provide a compliance in order to suppress the disturbance. A movement of the object, such as a mirror or a substrate table of the lithographic apparatus may result in an inaccuracy in the imaging of a pattern on the substate. The inaccuracy may translate into an overlay error which may adversely affect an accuracy of the lithographic apparatus.

### SUMMARY

It is desired to provide a lithographic apparatus having a high overlay accuracy. According to an aspect of the invention, there is provided a silencer configured to silence an acoustic wave in a thermal conditioning fluid in a thermal conditioning fluid duct, the silencer comprising
an open inlet configured to be connected to the thermal conditioning fluid duct to be in fluid communication with the thermal conditioning fluid in the thermal conditioning fluid duct,
a silencer housing comprising an inner cavity connected to the open inlet,
a compliant member arranged in the inner cavity, wherein the compliant member divides the inner cavity into a thermal conditioning fluid cavity and a gas cavity, wherein the thermal conditioning fluid cavity is connected to the open inlet and wherein the gas cavity forms a substantially closed space,
wherein the gas cavity comprises a plurality of gas channels extending in a direction substantially perpendicular to a surface of the compliant member facing the gas cavity.

According to an aspect of the invention, there is provided a thermal conditioning system configured to thermally condition an object, wherein the thermal conditioning system comprises a thermal conditioning fluid duct configured to be connected to the object and configured to provide a flow of the thermal conditioning fluid to the object, wherein the thermal conditioning system comprises at least two silencers according to the invention, the at least two silencers arranged in series along the thermal conditioning fluid duct.

According to an aspect of the invention, there is provided a lithographic apparatus comprising an object and a thermal conditioning system according to the invention to thermally condition the object. According to an aspect of the invention, there is provided a method of thermally conditioning an object of a lithographic apparatus, comprising providing a flow of a thermal conditioning fluid via a thermal conditioning fluid duct to the object, the method comprising silencing disturbances in a disturbance frequency band in the thermal conditioning fluid by at least two silencers according to any one of according to the invention, the at least two silencers arranged in series along the thermal conditioning fluid duct.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A and 2B depicts a highly schematic view of a part of a thermal conditioning system with silencers as may be employed in the invention;
   Figure 3A - 3C depict frequency response diagrams based on which an effect of the silencers will be explained;
- Figure 4A - 4C depict highly schematic views of embodiments of a silencer;
- Figure 5A and 5B depict views of an embodiment of a silencer according to the invention; and
- Figure 6 depicts a frequency response diagram based on which an effect of the silencer in accordance with Figure 5A and 5B will be explained.

### DETAILED DESCRIPTION

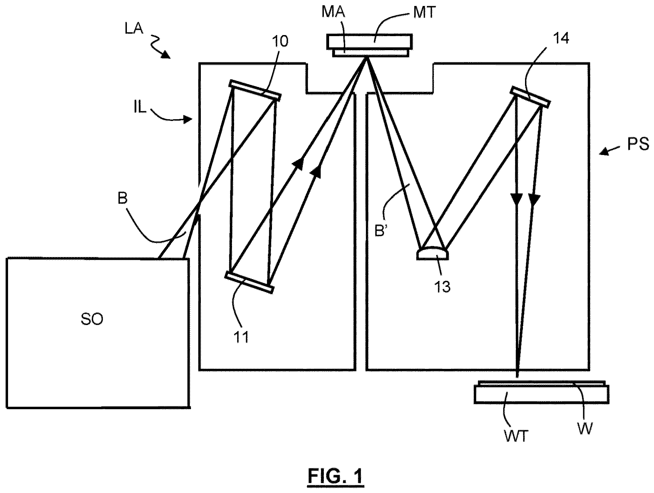

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

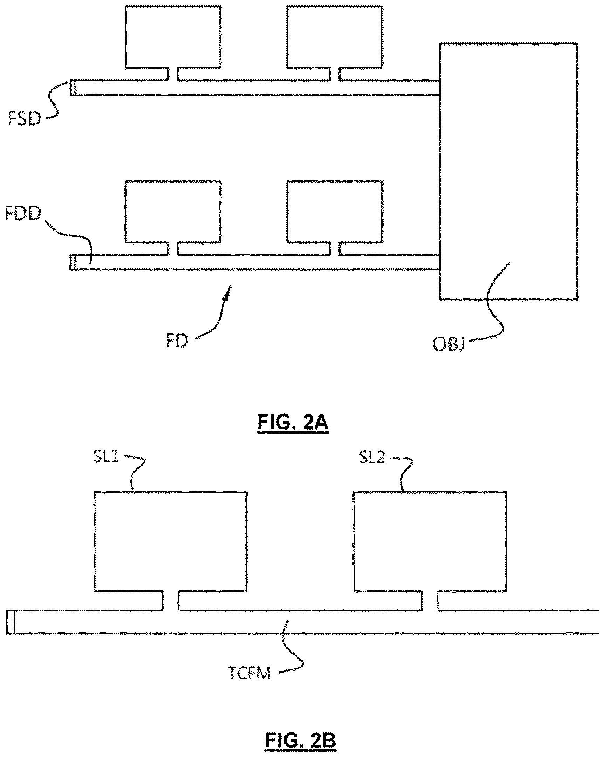

Figure 2A depicts a highly schematic view of a thermal conditioning system which comprises a fluid duct FD connected to an object OBJ. The thermal conditioning system is configured to thermally condition the object. The fluid duct, also referred to as thermal conditioning fluid duct, comprises a thermal conditioning fluid supply duct FSD to supply a thermal conditioning fluid to the object OBJ and a thermal conditioning fluid discharging duct FDD, to discharge the thermal conditioning fluid from the object OBJ. The fluid duct may form a fluid flow passage in or on the object, e.g. a fluid channel in the object or a fluid duct on the object, e.g. at a rear side of the object. The thermal conditioning fluid may be formed by any suitable fluid, such as a liquid, e.g. water or a gas. The thermal conditioning system may be configured to heat the object, to cool the object, thereby to provide that the object is stabilized at a desired temperature or within a desired temperature range. The object may for example be a mirror of a lithographic apparatus projection system or a stage, such as a wafer table of a lithographic apparatus. The thermal conditioning fluid may be supplied by any suitable supply means, such as a pump, a pressurizing means, etc.

Figure 2B depicts a schematic view of a part of the fluid supply duct of the thermal conditioning system in accordance with Figure 2A. According to an aspect of the present invention, the fluid supply duct and the fluid discharging duct are each provided with two silencers SL. The silencers may be understood as elements with a low hydraulic stiffness compared to a hydraulic stiffness of the thermal conditioning duct. The hydraulic stiffness may be understood as a ratio of increment in pressure relative to an increment in displaced volume of fluid, K_hyd=dp/dV, wherein p is an absolute pressure, V is a volume of gas.

A silencer as such has been observed to provide a attenuation to suppress disturbances. A silencer as such may provide a suppression of disturbances by e.g. a factor of 10 to a factor of 30. The inventors have however devised that a substantially higher suppression of disturbances may be achieved making use of such a silencer, which suppression may be orders of magnitude higher as compared to the known suppression by a factor of e.g. 10 to 30.

Reverting to Figure 2B, as explained above, at least two silencers are provided in the supply duct and at least two silencers are provided in the return duct. The silencers SL1, SL2 are arranged in series along the supply duct as well as along the discharging duct. Thus, along the supply duct, one of the at least two silencers is upstream in respect of the other one of the at least two silencers. Similarly, along the discharging duct, one of the at least two silencers is upstream in respect of the other one of the at least two silencers. The thermal conditioning fluid between the silencers SL1, SL2 provides for a thermal conditioning fluid mass TCFM.

The inventors have devised that the assembly of the two silencers in series with the thermal conditioning fluid in the duct between the silencers forming the thermal conditioning fluid mass, may provide a resonance behavior resulting in a roll off above the resonance frequency. By dimensioning the silencers, the compliance thereof and the thermal conditioning fluid mass between the silencers, the resonance frequency may be determined to be below a disturbance frequency band, hence enabling to more effectively suppress disturbances in the disturbance frequency band from being transferred via the fluid duct to the object.

Multiple silencers in series are provided with a capability to be effective up to higher frequencies (e.g. above 80Hz). Using at least two silencers in series, a gas volume of each silencer effectively creates a low-stiffness in the water circuit by generating a low hydraulic stiffness (K_hyd=dp/dV). Subsequently, the hydraulic stiffness of a gas volume can be derived to be K_hyd=yp/V (adiabatic conditions). In the above formulas, γ (gamma) is an adiabatic index, p is an absolute pressure, V is a volume of gas. By placing two silencers in series the mass in-between the silencers may start to resonate at a resonance frequency. Below this frequency there may be no additional benefit of multiple silencers, at this frequency there may be an amplification, however, above this frequency the mass in-between the silencers may start to decouple and effectively a -2 slope is gained. This is analogous with a mechanical mass-spring isolation system. In this way a significantly higher suppression may be reached by placing multiple silencers in series. Additionally by either decreasing the stiffness of the silencer (decreasing pressure or increasing gas volume) or increasing the hydraulic mass of the duct between the silencers M_(hyd duct)=ρL/A (increasing the length or decreasing the duct cross sectional area), this resonance frequency may be lowered, such that a higher reduction is achieved (especially relevant around the above mentioned frequency, e.g. 80Hz). Placing more than 2 silencers in series may be applied to create multiple masses in-between silencers that start to decouple, such that effectively a -4 slope or even higher may be reached. Tuning the stiffness of the silencer and the hydraulic mass of the duct between the silencers allows to effectively avoid amplification of resonances and to gain ultimo silencing performance. Placing multiple silencers in series with a sufficient distance in-between is currently the critical technology breakthrough for the introduction of DCM from a dynamics perspective.

Effectivity up to higher frequencies: The distance between the gas volume and the duct may limit the frequency up to which effective use of the gas volume may be obtained. This duct part is referred to as the neck of the silencer and the associated resonance frequency may be referred to as the Helmholtz frequency f_HR. Below this frequency the gas volume is effectively felt, at this frequency an additional suppression may be reached (low effort needed to compress gas volume) and above this frequency the gas volume is not effectively felt anymore. By either increasing the stiffness of the silencer (increasing pressure or decreasing gas volume) or decreasing the hydraulic mass of the neck of the silencers (decreasing the length or increasing the neck diameter), this resonance frequency may be increased, such that the gas volume is effectively felt for higher frequencies (especially relevant around 80Hz). To eliminate the risk of gas being dissolved over time a compliant interface is added. The requirement for this interface is that its stiffness is sufficiently low such that the sum of both the gas volume stiffness and that of the compliant interface still may still meet requirements. In addition the inertia of the bellow may be small enough such that the Helmholtz frequency may stay sufficiently high. Finally the structural resonance of the compliant interface may be sufficiently high, at least higher than the Helmholtz frequency, such that it doesn't deteriorate acoustic silencing performance.

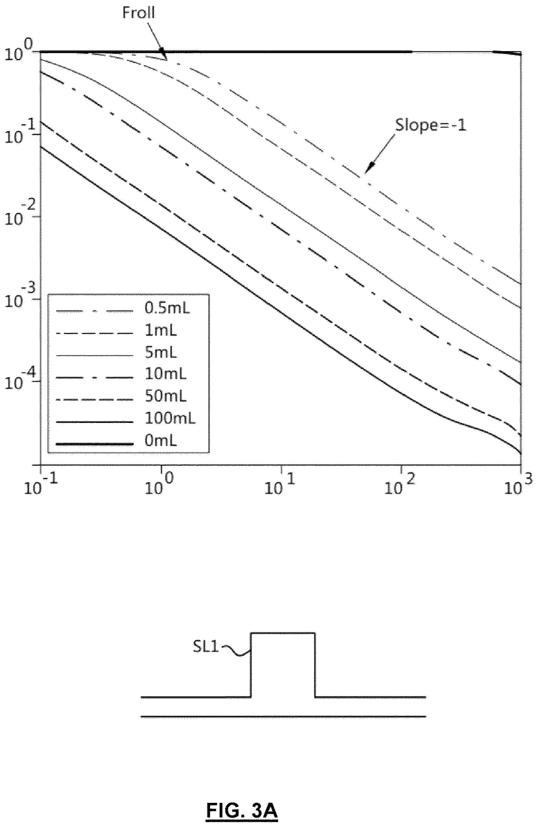

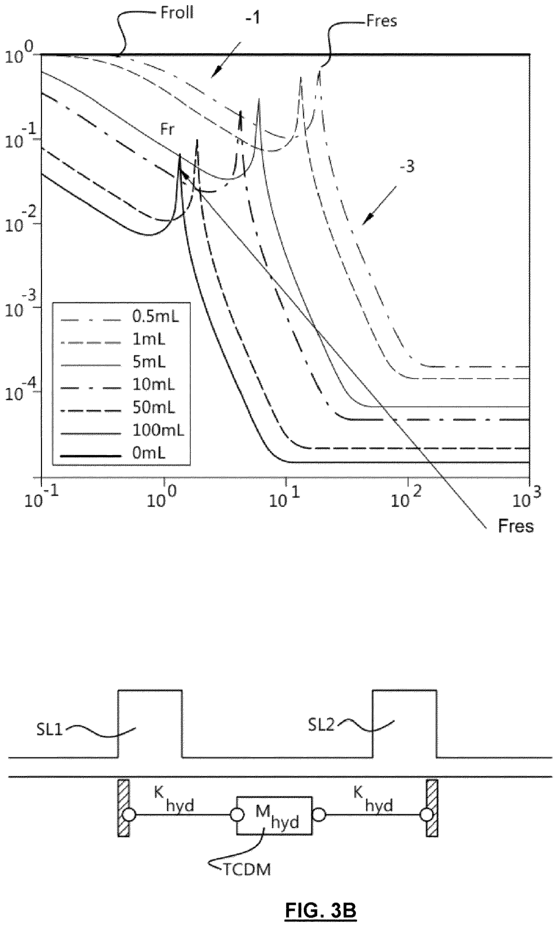

Figure 3A and 3B depicts diagrams where a transfer of a disturbance via the duct to the object is depicted on the vertical axis versus frequency on the horizontal axis. As depicted in Figure 3A, a single silencer in the supply duct FSD and in the return duct FRD provides, above a roll-off frequency Froll, a roll off of a factor 2 per octave, i.e. a factor 10 per frequency decade. As depicted in Figure 3B, two silencers in series in the supply duct and in the return duct may provide for a roll off of a factor 2 per octave from a roll of frequency Froll to a resonance frequency Fres, while providing a triple roll off, i.e. a roll off of a factor 8 per octave above the resonance frequency. The resonance frequency Fres may be determined by the resonance of the dual silencers with the mass of the thermal conditioning fluid in the duct between the two silencers.

Thus, as follows from the above, a single silencer in combination with a non-reflective acoustic boundary condition (critically damped), may provide a -1 slope, i.e. a factor 10 per frequency decade. Dual silencers in series may provide a -3 slope, i.e. a factor 1000 per frequency decade (-1 slope, i.e. the factor 10 per frequency decade may stem from the silencer in combination with a non-reflective acoustic boundary condition, -2 slope, i.e. a factor 100 per frequency decade, may stem from the decoupled mass in between the silencers).

In an embodiment, the at least two silencers form a resonator with the thermal conditioning fluid in the fluid duct interconnecting the at least two silencers. The thermal conditioning fluid in the duct interconnecting the at least two silencers in the supply duct respectively in the return duct, provides for a mass, while the silencers provide for a compliance. The mass of the thermal conditioning fluid between the silencers and the compliance of the silencers may exhibit a resonance behavior, as shown in Figure 3B by the resonance frequency Fres. A resonance behavior implies that two poles are involved in the frequency behavior, as a result if which, above the resonance frequency, a (further) roll off a factor 4 per octave is observed, i.e. a (further) factor 100 per frequency decade. In combination with the roll of the silencer in combination with the non-reflective acoustic boundary condition, a total of a factor 1000 per frequency decade is observed. The resonance frequency may be a resonance due to sloshing of the fluid in the duct between the silencers.

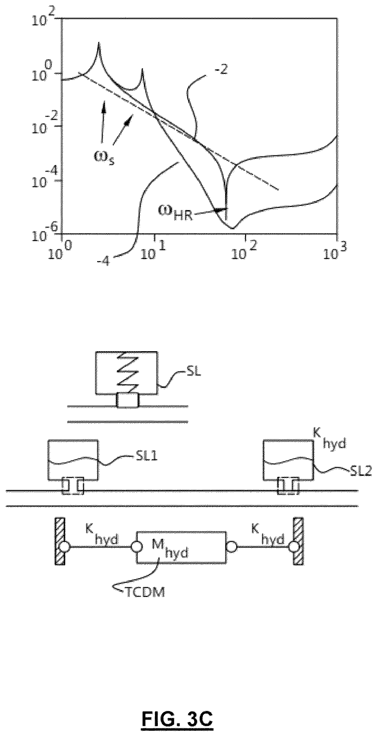

Figure 3C depicts a frequency diagram wherein a transfer of a disturbance via the duct to the object is depicted on the vertical axis versus frequency on the horizontal axis. As depicted in Figure 3C, a single silencer SL as such, in e.g. the supply duct and/or in the return duct, provides a Helmholz resonance at a Helmholz resonance frequency dip ω_{HR} at a square root of a quotient of the hydraulic compliance of the silencer and a hydraulic mass in a silencer fluid conduit, ω_{HR = √} (K_{Hyd}/M_{Hyd}), wherein ω_{HR} is the Helmholz resonance frequency, K_{Hyd} is the hydraulic compliance of the silencer and M_{Hyd} is the hydraulic mass in the silencer fluid conduit. The Helmholz resonance frequency dip ω_{HR} involves a roll off at a -2 slope. As further depicted in Figure 3C, two silencers in series, e.g. in the supply duct and/or in the return duct, may provide for a resonance peak at a sloshing frequency, the sloshing resonance frequency being equal to a square root of a quotient of [ two times the hydraulic compliance of the silencers and a hydraulic mass in the duct between the two silencers ], ω_{S = √} (2K_{Hyd}/M_{Hyd}).wherein ω_{S} is the sloshing frequency, 2K_{Hyd} is two times the hydraulic compliance of the silencers and M_{Hyd} is the hydraulic mass in the duct between the silencers. Thus, a silencer pair decouples the hydraulic mass in-between silencers (low stiffness element) achieving a -40 dB/ decade suppression in transfer of pressure over force input (-2 slope) above the sloshing resonance frequency. Multiple silencer pairs (N) allows to benefit from a multitude of decoupled masses resulting into a Nx -40dB/dec. For example, as depicted in Figure 3C, dual pairs provide for two sloshing resonance frequencies ω_{S}, providing for a -4 slope. The sloshing resonance frequency ω_{S} may be lower than the Helmholz resonance frequency ω_{HR}, as the larger hydraulic mass of the fluid between the silencers is involved. The sloshing resonance frequency ω_{S} may be dimensioned to be below a disturbance frequency band in which disturbances are to be suppressed, enabling to significantly suppress a propagation of the disturbances as a result of the -2 slope per silencer pair. Tuning the hydraulic mass in-between silencers (***M_hyd***)*,* hydraulic mass in a conduit between the duct and the silencer (***M_hyd***)*,* or the silencer compliancy (***K_hyd*** ) allows to optimize the suppression behavior. Dimensioning the hydraulic mass between the silencers and the silencer compliancy to provide that the sloshing frequencies of the silencer pairs are below the disturbance frequency band may allow to obtain the -2 slope per silencer pair in the disturbance frequency band enabling to suppress the disturbances in the disturbance frequency band by the -2 slope per silencer pair.

In an embodiment, the resonator is a series resonator. The series resonator enables to make use of the mass of the thermal conditioning fluid between the two silencers, hence enabling to use mass that is present in the fluid duct. As a result, no additional mass is required, resulting in little added weight.

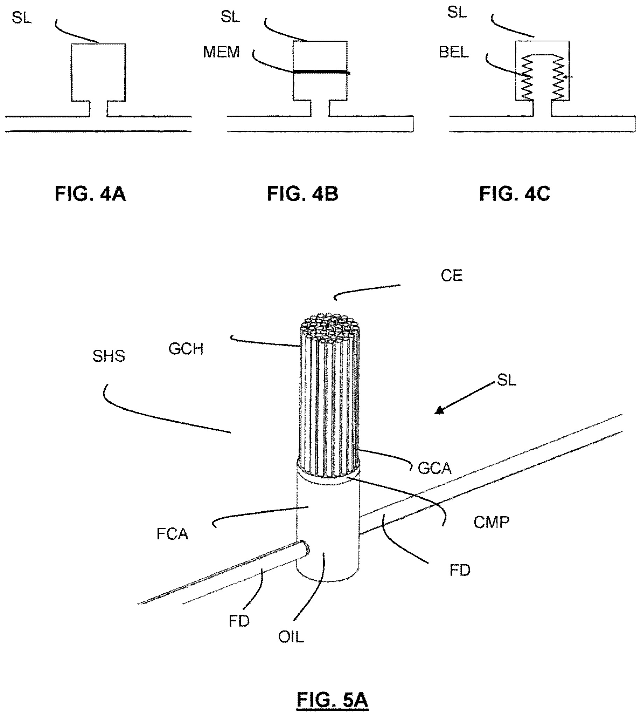

Figures 4A - 4C schematically depict three different embodiments of a silencer. The silencer SL as depicted in Figure 4A is formed by an interior space, which is partly filled with a gas, which gas may refrain from dissolving in the thermal conditioning fluid. A resilience may be formed by the gas when pressurized by the thermal conditioning fluid.

Figure 4B depicts a silencer SL comprising a membrane MEM which divides the interior space of the silencer into a part e.g. filled with a gas and a part filled with thermal conditioning fluid. A resiliency of the membrane, possibly in combination with a pressurizing of the gas, provides for a resiliency of the thermal conditioning fluid interacting with the silencer.

Figure 4C depicts a silencer SL comprising a membrane shaped as a bellow BEL which divides the interior space of the silencer into a part e.g. filled with a gas and a part filled with the thermal conditioning fluid. A resiliency of the membrane shaped as a bellow, possibly in combination with a pressurizing of the gas, provides for a resiliency of the thermal conditioning fluid interacting with the silencer.

Figure 5A depicts a perspective view of a silencer according to an embodiment of the invention. The silencer comprises a silencer housing SHS having an inner cavity CAV. The silencer comprises an open inlet OIL that is connected to a thermal conditioning fluid duct FD. The thermal conditioning fluid duct is configured to guide a thermal conditioning fluid to an object to be thermally conditioned, and/or to discharge the thermal conditioning fluid from the object to be thermally conditioned. The open inlet provides that the silencer is in fluid communication with the thermal conditioning fluid in the thermal conditioning fluid duct. The inner cavity is connected to the open inlet, and via the open inlet, with the thermal conditioning fluid duct. The silencer further comprises a compliant member CMP arranged in the inner cavity, wherein the compliant member divides the inner cavity into a thermal conditioning fluid cavity FCA and a gas cavity GCA. One surface of the compliant member faces the thermal conditioning fluid cavity and an opposite surface of the compliant member faces the gas cavity. The thermal conditioning fluid may hence flow from the thermal conditioning fluid duct, via the open inlet, to the thermal conditioning fluid cavity of the silencer. As the compliant member divides the cavity into the thermal conditioning fluid cavity connected to the open inlet and the gas cavity, the gas cavity forms a substantially closed space that may be filled with a gas. The compliant member is hence subject to a thermal conditioning fluid pressure at the one surface of the compliant member facing the thermal conditioning fluid cavity and subject to a gas pressure by the gas on the opposed surface of the compliant member facing the gas cavity.

The thermal conditioning fluid duct, also identified as fluid duct, may be formed by any fluid duct, such as a tube, as hose, a channel, a bore, or any combination thereof. For example, the thermal conditioning fluid duct may comprise a fluid flow passage in or on the object, e.g. a fluid channel in the object or a fluid duct on the object, e.g. at a rear side of the object. As another example, the fluid duct may comprise a fluid flow passage in or on the object in combination with a fluid supply duct to supply the thermal conditioning fluid to the object and a fluid discharging duct to discharge the thermal conditioning fluid from the object.

According to the invention, the gas cavity comprises a plurality of gas channels that may be filled with the gas. The gas channels extend in a direction substantially perpendicular to the surface of the compliant member facing the gas cavity. The gas cavity, or at least part of the gas cavity, is hence divided into a plurality of gas channels.

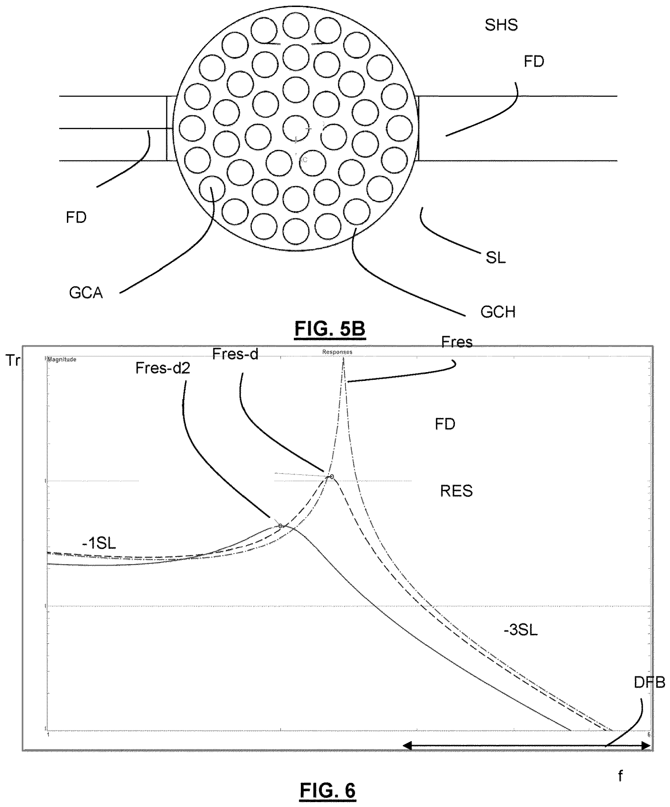

Figure 5B depicts a cross sectional view of the silencer, whereby the cross section intersects the gas channels in the gas cavity. Referring to the silencer as depicted in Figure 5A, the cross sectional view may be considered a top view onto the intersection. Figure 5B depicts the gas channels GCH in the gas cavity GCA.. The gas channels may extend parallel to each other. One end of the gas channels faces the surface of the complaint member facing the gas cavity, i.e. the surface of the compliant member facing the gas channels. The end of the gas channels facing the compliant member is an open end. The other, opposite end of the gas channels faces an outer wall of the silencer housing and may be a closed end CE. The gas channels thus extend from the compliant member to the outer wall of the silencer housing. The gas channels may be formed by respective holes or through-holes in the silencer housing, the holes or through holes extending from the complaint member to the outer wall of the silencer housing. In fact, the gas cavity may be formed by the plural gas channels.

The gas may comprise air, synthetic air, nitrogen or any other suitable gas or gas mixture.

The inventors have devised that the gas channels of the silencer may promote a damping of resonance peaks, as explained in more detail below.. As explained with reference to Figures 2A and 2B, two silencers may be provided in series in the supply duct of the thermal conditioning fluid duct and the discharging duct of the thermal conditioning fluid duct. The two silencers in series provide for a sloshing resonance mode that provides for a resonance at a resonance frequency Fres and an additional -2 slope above the resonance frequency. In the present example in accordance with Figure 2A and 2B, the slope below the resonance frequency is a -1 slope, providing that the slope above the resonance frequency is a -3 slope. Although the -3 slope provides for a enhanced attenuation of disturbances, e.g. vibrations, in a frequency range above the resonance frequency, a resonance peak at the resonance frequency may be high, providing for a relatively high transmission of vibrations at the resonance frequency. The resonance may be due to a resonating mass of the thermal conditioning fluid in the thermal conditioning duct between the two silencers and the compliance of the silencers. The compliance of the silencers may be determined by the stiffness of the gas in the gas cavity, possibly in combination with the stiffness of the compliant member. The resonance peak may provide for a transmission of disturbances at the resonance frequency to the object to be thermally conditioned.

The inventors have devised that the resonance peak at the resonance frequency Fres may be reduced by the gas channels in the gas cavity. The gas channels have been found to provide additional friction damping which has been found to promote a damping at the resonance frequency Fres. The damping has been found to be due to thermal damping on the one hand and viscous friction damping on the other hand. Thermal damping may be understood as the thermal effect caused by the compression of the gas in the gas channels due to the vibration, whereby a (local) temperature increase due to a (local) pressure increase in the gas may provide for convection to lower temperature parts, hence energy dissipation. The viscous damping may be understood as the friction effect of moving gas particles to the walls of the gas channels.

Figure 6 depicts a frequency diagram showing a frequency f at the horizontal axis and a transmissibility Tr of vibrations via the thermal conditioning fluid in the thermal conditioning fluid duct. Figure 6 depicts a damping by dual silencers in series along the thermal conditioning fluid duct in accordance with Figures 2A and 2B. As shown in Figure 6, the resonance peak Fres represents the resonance at the sloshing frequency. Adding damping appears to lower the resonance peak: adding damping in the thermal conditioning fluid duct appears to provide damping, reducing the resonance peak to Fres-d, while adding damping in the thermal conditioning fluid duct as well as in the gas cavity, by means of the gas channels according to the present invention, appears to further reduce the resonance peak to from Fres-d to Fres-d2. The damping by the gas channels comprised in the gas cavity hence appears to provide plural effects: On the one hand, the peak at the resonance frequency is reduced, on the other hand, the resonance frequency by itself is also reduced to some extent. The reduction of the resonance frequency promotes a silencing above the resonance frequency, as the lower resonance frequency provides that the transition from the -1 slope -1 SL below the resonance frequency to the more steep -3 slope -3SL above the resonance frequency starts at the lower resonance frequency Fres-d2, hence providing additional damping in the disturbance frequency band DFB above this frequency.

The gas channels each comprise a gas channel inlet facing the compliant member, to provide an acoustic coupling between the gas channels and the compliant member. The compliant member and the gas channels are arranged to enable the compliant member to vibrate without contacting the gas channels. A vibration in the thermal conditioning fluid in the thermal conditioning fluid duct, may propagate into the silencer via the open inlet, thereby propagating into the thermal conditioning fluid in the thermal conditioning fluid cavity. The vibration will hence interact with the compliant member, causing the compliant member to vibrate, which will be coupled into the gas channels in the gas cavity. A high extent of coupling between the compliant member and the gas channels, may promote the damping of the vibration in the thermal conditioning fluid in the thermal conditioning fluid chamber by the damping in the gas channels.

The other end of the gas channels may be closed, i.e. the gas channels may extend from the gas channel inlet to a substantially closed end, to enhance a damping effect in that the gas channels with closed end enhance a resistance on movement of the gas in the channels, thus contributing to enhancing a damping effect.

The gas channels may all have a same size, or may have different sizes, such as different diameters or different length. Possible undesired effects in the gas channels may be mitigated by making use of different sizes of the gas channels. A frequency dependent characteristic of the silencer may be adapted by the different sizes. Further, a larger excursion at a center of the compliant member, compared to the excursion at the edges of the compliant member, may be accompanied by different sizes of the gas channels. For example, a difference between the diameter of the gas channels facing the center of the compliant member and the diameter of the gas channels facing the edges of the compliant member may reflect the difference in excursion of the compliant member at the center versus at the edges, when being subject to a vibration. Although the above example refers to different diameters of the gas channels, the gas channels may likewise be provided with different lengths thereof.

The compliant member may comprises a membrane, such as a rubber membrane, or a bellow, such as a metal bellow.

The gas cavity may comprise a gas, preferably an air, synthetic air, carbondioxide, nitrogen or any gas mixture.

The thermal conditioning system according to the invention may comprise at least two of the silencers according to the invention, arranged in series along the thermal conditioning fluid duct. As described above, the gas channels of the silencers may promote a damping of the sloshing resonance, hence reducing a transmission of vibrations (or other disturbances) via the thermal conditioning fluid in the thermal conditioning fluid duct towards the object to be thermally conditioned by the thermal conditioning system. According to an aspect of the invention, there is provided a thermal conditioning system configured to thermally condition an object, wherein the thermal conditioning system comprises a thermal conditioning fluid duct configured to be connected to the object and configured to provide a flow of the thermal conditioning fluid to the object, wherein the thermal conditioning system comprises at least two silencers as described above with reference to Figures 5A and 5B, the at least two silencers arranged in series along the thermal conditioning fluid duct.

The thermal conditioning system may comprise a supply duct and a discharging duct, the supply duct to supply thermal conditioning fluid to the object and the discharging duct to discharge thermal conditioning fluid from the object. Both the supply duct and the discharging duct may form a path along which the disturbance may reach the object to be thermally conditioned. In order to provide the silencing at frequencies above the sloshing resonance frequency, in the supply duct as well as in the discharging duct, both the supply duct and the discharging duct may be provided with the silencers comprising the gas channels to dampen the sloshing resonance peak. According to an embodiment of the invention, the thermal conditioning fluid duct thus comprises a supply duct configured to be connected to the object and to supply the thermal conditioning fluid to the object and a discharging duct configured to be connected to the object and to discharge the thermal conditioning fluid from the object, wherein the supply duct and the discharging duct are each provided with the at least two silencers arranged in series along the supply duct and along the discharging duct respectively. The at least two silencers may form a resonator with the thermal conditioning fluid in the fluid duct, i.e. the thermal conditioning fluid duct, interconnecting the at least two silencers.

As the sloshing resonance provides for a steep slope, in the frequency response diagram, above the sloshing resonance frequency, the dual silencers that form the resonator may provide a high damping above the sloshing resonance frequency. According to an embodiment, the resonator is configured to attenuate disturbances in a disturbance frequency band, wherein a resonance frequency of the resonator is below the disturbance frequency band. The resonator may be a series resonator.

The thermal conditioning system described above may be comprised in a lithographic apparatus. The object to be thermally conditioned by the thermal conditioning system may be one of a projection system mirror of the projection system, a substrate table, a support to support a pattering device, a force frame and a sensor frame of the lithographic apparatus.
The invention may further be phrased as a method of thermally conditioning an object of a lithographic apparatus, comprising providing a flow of a thermal conditioning fluid via a thermal conditioning fluid duct to the object, the method comprising silencing disturbances in a disturbance frequency band in the thermal conditioning fluid by at least two silencers as described above with reference to Figures 5A and 5B, the at least two silencers arranged in series along the thermal conditioning fluid duct.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A silencer configured to silence an acoustic wave in a thermal conditioning fluid in a thermal conditioning fluid duct, the silencer comprising
an open inlet configured to be connected to the thermal conditioning fluid duct to be in fluid communication with the thermal conditioning fluid in the thermal conditioning fluid duct,
a silencer housing comprising an inner cavity connected to the open inlet,
a compliant member arranged in the inner cavity, wherein the compliant member divides the inner cavity into a thermal conditioning fluid cavity and a gas cavity, wherein the thermal conditioning fluid cavity is connected to the open inlet and wherein the gas cavity forms a substantially closed space,
wherein the gas cavity comprises a plurality of gas channels extending in a direction substantially perpendicular to a surface of the compliant member facing the gas cavity.

2. The silencer according to claim 1, wherein the gas channels each comprise a gas channel inlet facing the compliant member.

3. The silencer according to claim 1 or 2, wherein the gas channels extend from the gas channel inlet to a substantially closed end.

4. The silencer according to any one of the preceding claims, wherein the gas channels have different sizes.

5. The silencer according to any one of the preceding claims, wherein the compliant member comprises a membrane or a bellow.

6. The silencer according to any one of the preceding claims, wherein the gas cavity comprises a gas, preferably an air.

7. A thermal conditioning system configured to thermally condition an object, wherein the thermal conditioning system comprises a thermal conditioning fluid duct configured to be connected to the object and configured to provide a flow of the thermal conditioning fluid to the object, wherein the thermal conditioning system comprises at least two silencers according to any one of the preceding claims, the at least two silencers arranged in series along the thermal conditioning fluid duct.

8. The thermal conditioning system according to claim 7, wherein the thermal conditioning fluid duct comprising a supply duct configured to be connected to the object and to supply the thermal conditioning fluid to the object and a discharging duct configured to be connected to the object and to discharge the thermal conditioning fluid from the object, wherein the supply duct and the discharging duct are each provided with the at least two silencers arranged in series along the supply duct and along the discharging duct respectively.

9. The thermal conditioning system according to claim 8, wherein the at least two silencers form a resonator with the thermal conditioning fluid in the fluid duct interconnecting the at least two silencers.

10. The thermal conditioning system according to claim 9, wherein the resonator is configured to attenuate disturbances in a disturbance frequency band, wherein a resonance frequency of the resonator is below the disturbance frequency band.

11. The thermal conditioning system according to claim 9 or 10, wherein the resonator is a series resonator.

12. A lithographic apparatus comprising an object and a thermal conditioning system according to any one of claims 7 to 11 to thermally condition the object.

13. The lithographic apparatus according to claim 12, wherein the object is one of a projection system mirror, a substrate table, a support to support a pattering device, a force frame and a sensor frame of the lithographic apparatus.

14. A method of thermally conditioning an object of a lithographic apparatus, comprising providing a flow of a thermal conditioning fluid via a thermal conditioning fluid duct to the object, the method comprising silencing disturbances in a disturbance frequency band in the thermal conditioning fluid by at least two silencers according to any one of according to any one of claims 1 - 6, the at least two silencers arranged in series along the thermal conditioning fluid duct.
